# EUROPEAN PATENT APPLICATION

(11) **EP 4 596 489 A1**
(43) Date of publication of application: **06.08.2025**
(21) Application number: 23870940.6
(22) Date of filing: 27.09.2023
(51) Int. Cl.: B81B 7/00, B81C 1/00

(54) **WAFER-LEVEL PACKAGING STRUCTURE, MANUFACTURING METHOD THEREFOR, AND SENSOR**

(30) Priority: 29.09.2022 CN 202211201640; 29.09.2022 CN 202222650211 U
(71) Applicant: Hangzhou Hikmicro Sensing Technology Co., Ltd., Hangzhou Zhejiang 311501 (CN)
(72) Inventor: SONG, Yawei, Hangzhou, Zhejiang 311501 (CN); CHI, Hai, Hangzhou, Zhejiang 311501 (CN); XU, Zhenyu, Hangzhou, Zhejiang 311501 (CN)
(74) Representative: Michalski Hüttermann & Partner Patentanwälte mbB
(86) International application number: PCT/CN2023/122117
(87) International publication number: WO 2024/067713

(57) **Abstract**

A wafer-level packaging structure, comprising a device wafer (10), a plurality of reference device regions (20), and a thickened intermediate layer wafer (30). The reference device regions (20) are arranged on the device wafer (10) and are configured to provide reference devices (21); the thickened intermediate layer wafer (30) is arranged on the device wafer (10) and comprises first sub-portions (31) and second sub-portions (32) which are connected to each other, each first sub-portion (31) being arranged around a reference device (21); one reference device region (20) is arranged in the area enclosed by a first sub-portion (31), and the orthographic projection of each second sub-portion (32) on the device wafer (10) covers a reference device region (20); in the direction away from the device wafer (10), the surface of each second sub-portion (32) away from a first sub-portion (31) is inclined towards the side close to the first sub-portion (31). The wafer-level packaging structure can improve the signal transmission precision of wafer-level sensors. Further provided are a sensor and a manufacturing method for the wafer-level packaging structure.

## Description

### TECHNICAL FIELD

The present disclosure relates to the field of packaging technology for integrated circuit, and particularly to a wafer-level packaging structure and manufacturing method therefor, and a sensor.

### BACKGROUND

Micro Electro Mechanical Systems (MEMS for short) is a miniature integrated system that uses integrated circuit manufacturing technology and micro-machining technology to fabricate microsensors and micro-actuators on a single chip. Among them, MEMS sensors have advantages of small size, light weight, low power consumption, high reliability, high sensitivity, and easy integration, and are gradually replacing traditional mechanical sensors.

Multiple MEMS sensors can first be packaged to obtain an overall wafer-level packaging structure, and then the wafer-level packaging structure is diced to form multiple independent packaging structures of MEMS sensor. A packaging structure of MEMS sensor includes a MEMS sensor. The MEMS sensor is easily affected by external environmental factors, causing a change in its own resistance. As a result, electrical signal output by the MEMS sensor will deviate from an actual situation, affecting performance of the MEMS sensor. Usually, the performance of the MEMS sensor can be improved by adjusting its packaging structure. Moreover, since the packaging cost of the MEMS sensor accounts for approximately 50% to 80% of the total cost, how to configure the packaging structure of the MEMS sensor is a key research direction for those skilled in the art.

### SUMMARY

Embodiments of the present disclosure provide a wafer-level packaging structure and manufacturing method therefore, and a sensor.

To realize the above objective, embodiments of the present disclosure adopts the following technical solutions.

In a first aspect, a wafer-level packaging structure is provided. The wafer-level packaging structure includes a device wafer, a plurality of reference device regions, and a thickened intermediate layer wafer. The plurality of reference device regions are disposed on the device wafer and are configured to accommodate reference devices. The thickened intermediate layer wafer is disposed on the device wafer. The thickened intermediate layer wafer includes a plurality of thickened intermediate layer regions, and each thickened intermediate layer region includes a first sub-portion and a second sub-portion, with the second sub-portion being connected to the first sub-portion. Here, one reference device region is disposed within an area enclosed by the first sub-portions, and the orthographic projection of the second sub-portion on the device wafer covers the reference device region.

In some examples, in a direction away from the device wafer, a surface of the second sub-portion away from the first sub-portion is inclined toward a side close to the first sub-portion; and/or, the surface of the second sub-portion away from the first sub-portion is stepped; and/or, a plane where the surface of the second sub-portion away from the first sub-portion is located is perpendicular to the device layer.

In some examples, the wafer-level packaging structure further includes a plurality of functional device regions. The functional device regions each are disposed within an area enclosed by the first sub-portion, are configured to accommodate functional devices, and output sensing signals. In a direction perpendicular to the device wafer, two ends of the second sub-portion respectively are flush with two ends of the first sub-portion, and the orthographic projection of the second sub-portion on the device wafer does not overlap with the functional device region.

In some examples, the thickened intermediate layer region has a via hole. An opening of the via hole away from the functional device is larger than an opening of the via hole close to the functional device. A boundary of an orthographic projection of the via hole on the device wafer surrounds the functional device region. In a direction away from the device wafer, an area of a cross-section of the via hole increases.

In some examples, the thickened intermediate layer region further includes at least one blocking layer. The at least one blocking layer is disposed on a side of the second sub-portion close to the reference device region and is connected to the second sub-portion. An orthographic projection of the blocking layer on the device wafer covers the reference device regions and the at least one blocking layer is configured to block electromagnetic waves from irradiating the reference device.

In some examples, the thickened intermediate layer region further includes at least one getter. An orthographic projection of the at least one getter on the device wafer does not overlap with orthographic projections of the functional device region on the device wafer; and/or, the blocking layer includes the getter.

In some examples, the wafer-level packaging structure further includes a capping wafer. The capping wafer is disposed on a side of the thickened intermediate layer wafer away from the device wafer. The capping wafer, the plurality of thickened intermediate layer regions, and the device wafer enclose a plurality of sealed cavities. One reference device region and one functional device region form a group, and at least one group of functional device region and reference device region is located within one cavity.

In some examples, there is a gap between an area within the cavity and formed by extending edges of the functional device region in a direction perpendicular to the device wafer and a surface of the second sub-portion away from the first sub-portion.

In some examples, the wafer-level packaging structure further includes at least one buffer member. The at least one buffer member is located between the device wafer and the capping wafer, with one end connected to the device wafer and other end connected to the capping wafer.

In a second aspect, a sensor is provided. The sensor includes a device layer, a reference device, and a thickened intermediate layer. The reference device is disposed on the device layer. The thickened intermediate layer is disposed on the device layer and includes a first sub-portion and a second sub-portion that are connected. One reference device is disposed within an area enclosed by the first sub-portion, and an orthographic projection of the second sub-portion on the device wafer covers the reference device.

In some examples, in a direction away from the device layer, a surface of the second sub-portion away from the first sub-portion is inclined toward a side close to the first sub-portion; and/or, the surface of the second sub-portion away from the first sub-portion is stepped; and/or, a plane where the surface of the second sub-portion away from the first sub-portion is perpendicular to the device layer.

In some examples, a surface of the second sub-portion close to the device layer is connected to a surface of the first sub-portion close to the device layer and both are located in a same plane.

In some examples, the sensor further includes a functional device. The functional device is disposed within the area enclosed by the first sub-portion and is configured to output a sensing signal. The orthographic projection of the second sub-portion on the device layer does not overlap with the functional device. In a direction perpendicular to the device wafer, two ends of the second sub-portion respectively are flush with two ends of the first sub-portion, and external electromagnetic waves are incident on the functional device along an inclined surface of the second sub-portion away from the first sub-portion.

In some examples, the thickened intermediate layer has a via-hole. An opening of the via-hole away from the functional device is larger than an opening of the via hole close to the functional device. A boundary of an orthographic projection of the via hole on the device wafer surrounds the functional device region. In the direction away from the device wafer, an area of a cross-section of the via hole increases.

In some examples, the sensor further includes a blocking layer. The blocking layer is disposed on the side of the second sub-portion close to the reference device and is connected to the second sub-portion. The orthographic projection of the blocking layer on the device layer covers the reference device and is configured to block electromagnetic waves from irradiating the reference device.

In some examples, the sensor further includes a getter. An orthographic projection of the getter on the device layer does not overlap with the orthographic projection of the functional device on the device layer; and/or, the blocking layer includes the getter.

In some examples, the sensor further includes a capping layer. The capping layer is disposed on a side of the thickened intermediate layer away from the device wafer. The capping layer, the thickened intermediate layer, and the device layer enclose a sealed cavity, and the functional device and the reference device are located within the cavity.

In some examples, there is a gap between an area within the cavity and formed by extending edges of the functional device in the direction perpendicular to the device wafer and the surface of the second sub-portion away from the first sub-portion.

In some examples, the at least one buffer member includes at least two buffer members. At least one of the at least two buffer members is located between the device layer and the thickened intermediate layer, with one end connected to the device layer and other end connected to the thickened intermediate layer. At least one of the at least two buffer members is located between the capping layer and the thickened intermediate layer, with one end connected to the capping layer and other end connected to the thickened intermediate layer.

In a third aspect, a manufacturing method of a wafer-level packaging structure is provided. The manufacturing method of the wafer-level packaging structure is used to manufacture the wafer-level packaging structure provided in any one of the examples in the first aspect. The manufacturing method includes: preparing a device wafer, where the device wafer has a plurality of reference device regions, and a reference device is provided within each of the reference device regions.

Preparing a thickened intermediate layer wafer, where the thickened intermediate layer wafer includes a plurality of thickened intermediate layer regions, and each of the thickened intermediate layer regions includes a first sub-portion and a second sub-portion that are connected. The thickened intermediate layer wafer is aligned and bonded to a surface of the device wafer where the reference devices are provided. One reference device region is located within an area enclosed by the first sub-portion, and an orthographic projection of the second sub-portion on the device wafer covers the reference device region.

In some examples, in a direction away from the device wafer, a surface of the second sub-portion away from the first sub-portion is toward a side close to the first sub-portion; and/or, the surface of the second sub-portion away from the first sub-portion is stepped; and/or, a plane where the surface of the second sub-portion away from the first sub-portion is perpendicular to the device layer.

In some examples, forming the thickened intermediate layer wafer includes: forming second sealing members and third sealing members on two opposite surfaces of the thickened intermediate layer wafer; forming blocking layers on a surface of the thickened intermediate layer wafer where the third sealing members are located, the third sealing members surrounding the blocking layers respectively; and etching the thickened intermediate layer wafer to form via-holes, where a wall of each of the via-hole is the surface of the second sub-portion away from the first sub-portion.

In some examples, preparing the device wafer further includes: providing a plurality of functional device regions on the device wafer, where a functional device is provided within each of functional device regions, and external electromagnetic waves are incident on the functional device along an inclined surface of the second sub-portion away from the first sub-portion.

There is a gap between the functional device region and the reference device region, and the functional device is located within a boundary of an orthographic projection of the via-hole on the device wafer. Fourth sealing members are formed on the device wafer, and the fourth sealing members surround the reference device regions and the functional device regions. The fourth sealing members are bonded to the third sealing members of the thickened intermediate layer wafer by solder, and orthographic projections of the blocking layers on the device wafer cover the reference device regions.

In some examples, the manufacturing method further includes: preparing a capping wafer, where preparing the capping wafer includes forming first sealing members and getters on the capping wafer. The device wafer, the thickened intermediate layer wafer, and the capping wafer form a wafer-level packaging structure. The first sealing members are bonded to the second sealing members of the thickened intermediate layer wafer by solder, and orthographic projections of the getters on the device wafer do not overlap with orthographic projections of the functional devices on the device wafer.

### BRIEF DESCRIPTION OF DRAWINGS

Fig. 1 is a schematic structural diagram of a wafer-level packaging structure provided in one or more embodiments of the present disclosure;
Fig. 2 is a schematic structural diagram along section line A-A of Fig. 1;
Fig. 3 is a schematic structural diagram of a part G in Fig. 2;
Fig. 4 is a schematic structural diagram of a sensor provided in one or more embodiments of the present disclosure;
Fig. 5 is a schematic structural diagram along section line B-B of Fig. 4;
Fig. 6 is another schematic structural diagram along section line B-B of Fig. 4;
Fig. 7 is yet another schematic structural diagram along section line B-B of Fig. 4;
Fig. 8 is yet another schematic structural diagram along section line B-B of Fig. 4;
Fig. 9 is yet another schematic structural diagram along section line B-B of Fig. 4;
Fig. 10 is yet another schematic structural diagram along section line B-B of Fig. 4;
Fig. 11 is yet another schematic structural diagram along section line B-B of Fig. 4;
Fig. 12 is yet another schematic structural diagram along section line B-B of Fig. 4;
Fig. 13 is yet another schematic structural diagram along section line B-B of Fig. 4;
Fig. 14 is yet another schematic structural diagram along section line B-B of Fig. 4;
Fig. 15 is yet another schematic structural diagram along section line B-B of Fig. 4;
Fig. 16 is yet another schematic structural diagram along section line B-B of Fig. 4;
Fig. 17 is yet another schematic structural diagram along section line B-B of Fig. 4;
Fig. 18 is yet another schematic structural diagram along section line B-B of Fig. 4;
Fig. 19 is a schematic diagram of manufacturing steps of a wafer-level packaging structure provided in one or more embodiments of the present disclosure;
Fig. 20 is another schematic diagram of manufacturing steps of a wafer-level packaging structure provided in one or more embodiments of the present disclosure.

### DETAILED DESCRIPTION

Technical solutions in some embodiments of the present disclosure will be clearly and completely described below in conjunction with the accompanying drawings. Obviously, the described embodiments are only a part of the embodiments of the present disclosure, rather than all of them.

Unless the context requires, otherwise, throughout the specification and the claims, the term "include" is construed as an open and inclusive meaning, that is, "including, but not limited to". Words such as "exemplarily" or "for example" are used to indicate examples, illustrations or explanations. Any embodiment or design scheme described as "exemplarily" or "for example" in the present disclosure should not be construed as being more preferred or having more advantages than other embodiments or design schemes. Precisely, the use of words such as "exemplary" or "for example" is intended to present relevant concepts in a specific manner.

When describing some embodiments, the term "electrically connected" may be used to indicate that two or more components have direct physical contact or electrical contact. The embodiments disclosed herein are not necessarily limited to the content herein.

The use of "suitable for" or "configured to" herein means open and inclusive language, which does not exclude devices that are suitable for or configured to perform additional tasks or steps.

The terms "first" and "second" are only used for descriptive purposes and should not be construed as indicating or implying relative importance or implicitly indicating the quantity of the indicated technical features. Thus, a feature defined as "first" or "second" may explicitly or implicitly include one or more of such features. In the description of the present disclosure, unless otherwise specified, "a plurality of" means two or more.

The wafer-level packaging structure can realize packaging and testing of MEMS sensors on a wafer, and it is a packaging technology widely used in mass production of MEMS devices. The wafer-level packaging structure adopts technical means of packaging first and then dicing, which avoids problems such as contamination and damage to microstructures during dicing process. Design of the MEMS sensors and packaging design of the wafer-level package may be considered combined and carried out simultaneously, which will improve design efficiency and reduce design cost. In the whole process from the manufacturing and packaging of MEMS sensors to completion of products in wafer-level packaging, intermediate links are greatly reduced and cycle is shortened significantly, thus reducing the cost. Therefore, how to design the structure of wafer-level packaging to improve packaging effect and performance of MEMS sensors is a key research direction for those skilled in the art.

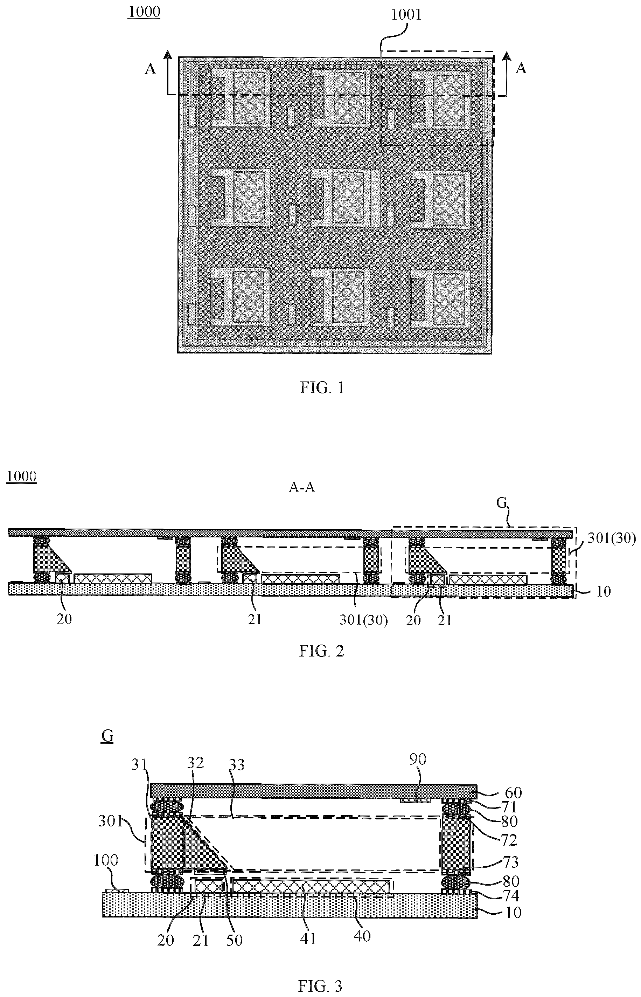

To this end, the present disclosure provides a wafer-level packaging structure. As shown in Fig. 1 and Fig. 2, in the wafer-level packaging structure 1000, multiple MEMS sensors are packaged on a relatively large-sized wafer substrate, and then dicing is performed to divide it into multiple individual wafer-level packaging structures 1001 (i.e., sensors, sensor 1001 is described as an example hereinafter).

As shown in Fig. 2, the wafer-level packaging structure 1000 includes a device wafer 10, a plurality of reference device regions 20 and a thickened intermediate layer wafer 30.

The device wafer 10 serves as a substrate supporting the MEMS sensors. Exemplarily, a material of the device wafer 10 includes one or more of silicon chip, quartz chip, sapphire, and ceramic. For instance, the material of the device wafer 10 includes a silicon chip. Exemplarily, a shape of the device wafer 10 may be a circular, rectangular, or polygonal substrate. For instance, the device wafer 10 may be rectangular in shape. The specific configuration may be set according to actual requirements.

As shown in Fig. 2, the thickened intermediate layer wafer 30 is disposed on the device wafer 10, and the thickened intermediate layer wafer 30 includes a plurality of thickened intermediate layer regions 301. As shown in Fig. 3, each thickened intermediate layer region 301 includes a first sub-portion 31 and a second sub-portion 32; and the second sub-portion 32 is connected with the first sub-portion 31. One reference device region 20 is disposed within an area surrounded by the first sub-portion 31; and an orthographic projection of the second sub-portion 32 on the device wafer 10 covers the reference device region 20. In one embodiment, in a direction away from the device wafer 10, a surface of the second sub-portion 32 away from the first sub-portion 31 may be inclined towards a side close to the first sub-portion 31.

It should be noted that the second sub-portion 32 of the thickened intermediate layer region 301 is connected to the first sub-portion 31, i.e., a connecting surface between the first sub-portion 31 and the second sub-portion 32 is an interface of the two. Along a direction perpendicular to the device wafer 10, both ends (end surfaces) of the second sub-portion 32 are flush with corresponding ends (end surfaces) of the first sub-portion 31. Herein, there is no restriction on the thickness of the interface of the two along a direction parallel to the device wafer 10.

As shown in Fig. 3, the reference device regions 20 are disposed on the device wafer 10 and are configured to accommodate reference devices 21. It shall be understood that the reference device 21 is configured to output a reference signal so as to enable the wafer-level packaging structure 1000 to judge or calibrate accuracy of actual output signal based on the reference signal, thereby improving performance of the sensors 1001 formed by dicing the wafer-level packaging structure 1000. An orthographic projection of the second sub-portion 32 of the thickened intermediate layer region 301 on the device wafer 10 covers the reference device region 20, reducing influence of external electromagnetic waves on a value of the reference signal output by the reference device 21 and enhancing accuracy of the output signal from the reference device region 20.

In some examples, the thickened intermediate layer wafer 30 may be a substrate of a same specification (shape and size) as the device wafer 10. For example, a shape of the thickened intermediate layer wafer 30 is basically the same as that of the device wafer 10, and may be rectangular. For example, the side length or diameter of the thickened intermediate layer wafer 30 is basically the same as that of the device wafer 10, and may be 8 inches, 12 inches or the like. For example, a thickness of the thickened intermediate layer wafer 30 is in a range of 5µm to 5mm. The thickness of the thickened intermediate layer wafer 30 may be selected and set according to specification and requirements of the packaged MEMS sensors. For instance, the thickness of the thickened intermediate layer wafer 30 is 5µm, 20µm, 100µm, 1mm, or 5mm.

In some examples, as shown in Fig. 3, the wafer-level packaging structure 1000 further includes a plurality of functional device regions 40. The functional device region 40 is disposed within an area enclosed by the first sub-portion 31 and is configured to accommodate one or more functional devices 41 and output sensing signals. Exemplarily, the functional device 41 is one or more MEMS devices and may include one or more of MEMS devices such as gyroscopes, accelerometers, pressure gauge, infrared focal plane arrays, and the like. For example, the functional device 41 includes an infrared focal plane array.

The orthographic projection of the second sub-portion 32 on the device wafer 10 does not overlap with the functional device region 40; and external electromagnetic waves irradiate the functional device 41 along the inclined surface of the second sub-portion 32 away from the first sub-portion 31. An inclination degree of the surface of the second sub-portion 32 away from the first sub-portion 31 can be set according to requirements, so as to increase electromagnetic waves irradiating the functional device 41 and improve the sensing effect of the functional device 41.

Exemplarily, the inclination degree of the surface of the second sub-portion 32 away from the first sub-portion 31 may be set according to a distance and relative positional relationship between the functional device 41 and the second sub-portion 32. The present disclosure does not impose any restrictions on this. For instance, the orthographic projection of the second sub-portion 32 on the device wafer 10 can exactly cover the reference device region 20. A cross-section of the second sub-portion 32 is a right triangle, and the cross-sectional area decreases in the direction away from the first sub-portion 31, so that external electromagnetic waves can irradiate the functional device 41 along the smooth inclined surface of the second sub-portion 32 away from the first sub-portion 31.

It should be noted that considering a manufacturing process of the second sub-portion 32, the orthographic projection of the second sub-portion 32 on the device wafer 10 can exactly cover the reference device region 20. Alternatively, the second sub-portion 32 is arranged surrounding the reference device region 20 (for example, the orthographic projection of the second sub-portion 32 on the device wafer 10 is a closed ring or an unclosed ring), and the orthographic projection of a part of the second sub-portion 32 on the device wafer 10 covers the reference device region 20. The present disclosure does not impose any restrictions on the specific structure of the second sub-portion 32 as long as the orthographic projection of the second sub-portion 32 on the device wafer 10 covers at least the reference device region 20.

In some examples, as shown in Fig. 3, the thickened intermediate layer region 301 has a via hole 33. An opening of the via hole 33 away from the functional device region 40 is larger than an opening of the via hole 33 close to the functional device region 40. Moreover, a boundary of an orthographic projection of the via hole 33 on the device wafer 10 surrounds the functional device region 40. That is to say, in the direction away from the device wafer 10, the cross-sectional area of the via hole 33 increases. Herein, the increase in the cross-sectional area of the via hole 33 means that planes where the sidewalls of the via hole 303 are located respectively are not perpendicular to a plane where the device wafer 10 is located.

In this way, the boundary of the orthographic projection of the smallest opening of the via hole 33 on the device wafer 10 surrounds the functional device region 40 to expose the functional device region 40, which is beneficial to improving the effect of receiving electromagnetic wave by the functional device 41 and enhancing the sensing performance of the functional device 41. Moreover, the opening of the thickened intermediate layer region 301 on the side away from the functional device region 40 is relatively large. Since electromagnetic waves are not incident vertically on the functional device region 40, more electromagnetic waves will pass through the opening of the via hole 33 away from the device wafer 10 to irradiate the functional device 41, thus improving the sensing performance of the functional device 41.

The shape enclosed by the boundary of the orthographic projection of the via hole 33 on the device wafer 10 can be any one or more of rectangle, circle, and polygon, which can be selected and set according to the shape of the functional device 40. The via hole 303 may be formed as a through hole by etching the thickened intermediate layer region 31 using a reactive ion etching process. The etching process can adopt wet etching, that is, the thickened intermediate layer wafer 30 to be etched is placed in an etching solution with a determined chemical composition and a fixed temperature for etching. The etching solution has different etching rates for different crystal planes of the thickened intermediate layer wafer 30, and the required via hole 33 or shielding structure can be fabricated on the thickened intermediate layer wafer 30.

In some examples, as shown in Fig. 3, the thickened intermediate layer region 301 further includes at least one blocking layer 50. The at least one blocking layer 50 is arranged on a side of the second sub-portion 32 of the thickened intermediate layer region 301 close to the reference device region 20 and is connected to the second sub-portion 32. An orthographic projection of the blocking layer 50 on the device wafer 10 covers the reference device region 20 and the blocking layer 50 is configured to block electromagnetic waves from irradiating the reference device 21.

Exemplarily, one blocking layer or two blocking layers 50 arranged side by side can be provided on the side of the second sub-portion 32 close to the reference device region 20 to expand the blocking area. Alternatively, one or two blocking layers 50 can be stacked on the side of the second sub-portion 32 close to the reference device region 20 to enhance the blocking effect, further reducing the influence of external electromagnetic waves on the magnitude of the reference signal output by the reference device 21, and improving accuracy of actual output signal of the wafer-level packaging structure 1000.

A material of the blocking layer 50 includes metal or other materials that can effectively block electromagnetic waves. Exemplarily, the material of the blocking layer 50 includes one or more of titanium, zirconium alloy, titanium alloy, gold, platinum, chromium, and nickel. For instance, the material of the blocking layer 50 includes titanium alloy.

In some examples, as shown in Fig. 3, the wafer-level packaging structure 1000 further includes a capping wafer 60. The capping wafer 60 is arranged on a side of the thickened intermediate layer wafer 30 away from the device wafer 10. For example, the capping wafer 60 is one or more of substrate materials such as silicon chip, germanium chip, and glass. For instance, the capping wafer 60 is a silicon chip.

Please continue to refer to Fig. 3, the capping wafer 60, the plurality of thickened intermediate layer regions 301, and the device wafer 10 enclose multiple sealed cavities. One reference device region 20 and one functional device region 40 form a group; and at least one group of the functional device region 40 and the reference device region 20 is located within one cavity.

In some examples, there is a gap between the region within the cavity and enclosed by extending the edges of the functional device region 40 in the direction perpendicular to the device wafer 10 and the surface of the second sub-portion 32 away from the first sub-portion 31. In this way, while ensuring that the electromagnetic waves incident in the direction perpendicular to the device wafer 10 irradiate the functional device region 40, at least some electromagnetic waves in the cavity that are not blocked by the second sub-portion 33 can irradiate the functional device region 40, thus improving the effect of the functional device region 40 in sensing electromagnetic waves.

In some embodiments, as shown in Fig. 3, the thickened intermediate layer region 301 further includes at least one getter 90. The getter 90 is located within the cavity. In this way, the getter 90 can absorb residual gas in the cavity and exhaust gas generated during operation of the MEMS device, improving quality of vacuum environment in the cavity, which is beneficial to increasing service life of MEMS device. For example, the getter 90 may be a non-evaporable getter, such as one or more of titanium, zirconium alloy, and titanium alloy. For instance, the getter 90 includes titanium alloy.

An orthographic projection of the getter 90 on the device wafer 10 does not overlap with the orthographic projection of the functional device region 40 on the device wafer 10; and/or, when the thickened intermediate layer region 301 includes the blocking layer 50, the blocking layer 50 includes the getter 90.

Exemplarily, the orthographic projection of the getter 90 on the device wafer 10 can at least partially overlap with the orthographic projection of the blocking layer 50 on the device wafer 10, and does not overlap with the orthographic projection of the functional device region 40 on the device wafer 10.

Alternatively, since the material used for the getter 90 include elemental metals or alloys, and elemental metals or alloys can achieve the effect of blocking electromagnetic waves, therefore, based on the function of the blocking layer 50, the material of the blocking layer 50 can be the same as that of the getter 90, or the blocking layer 50 includes the getter 90. In this way, the blocking layer 50 and the getter 90 can be fabricated using the same material and the same manufacturing process, reducing the number of process steps in the entire manufacturing process of the wafer-level packaging structure 1000.

In some embodiments, the wafer-level packaging structure 1000 further includes at least one buffer member. The at least one buffer member is located between the device wafer 10 and the capping wafer 60, and one end of the buffer member is connected to the device wafer 10, and the other end is connected to the capping wafer 60.

It can be understood that a material used for the buffer member has a certain strength and plasticity, playing a supporting role. A height of the buffer member is related to a volume of the solder 80 or the thickness of the thickened intermediate layer wafer 30, and can be set according to the actual conditions.

In some examples, the at least one buffer member includes a single buffer member, which is in a ring-shaped structure and is arranged along the edge surrounding the entire sensor 1001. When the wafer-level packaging structure 1000 includes a plurality of sensors 1001 arranged in a 3×3 array, a ring-shaped buffer member is arranged on sides of the outermost 8 sensors 1001 close to the edge of the device wafer 10. This ring-shaped buffer member 110 can provide a gap that maintains a certain distance between the device wafer 10 and the capping wafer 60.

Alternatively, the at least one buffer member includes two buffer members. The buffer members each are of a ring-shaped structure. One buffer member is located between the device wafer 10 and the thickened intermediate layer wafer 30, with one end connected to the device wafer 10 and the other end connected to the thickened intermediate layer wafer 30. This buffer member 110 surrounds all the sensors 1001 within the wafer-level packaging structure 1000 along the edge of the device wafer 10 in the wafer-level packaging structure 1000. The other buffer member is situated between the capping wafer 60 and the thickened intermediate layer wafer 30, with one end connected to the capping wafer 60 and the other end connected to the thickened intermediate layer wafer 30. This buffer member 110 surrounds all the sensors 1001 within the wafer-level packaging structure 1000 along the edge of the device wafer 10 in the wafer-level packaging structure 1000.

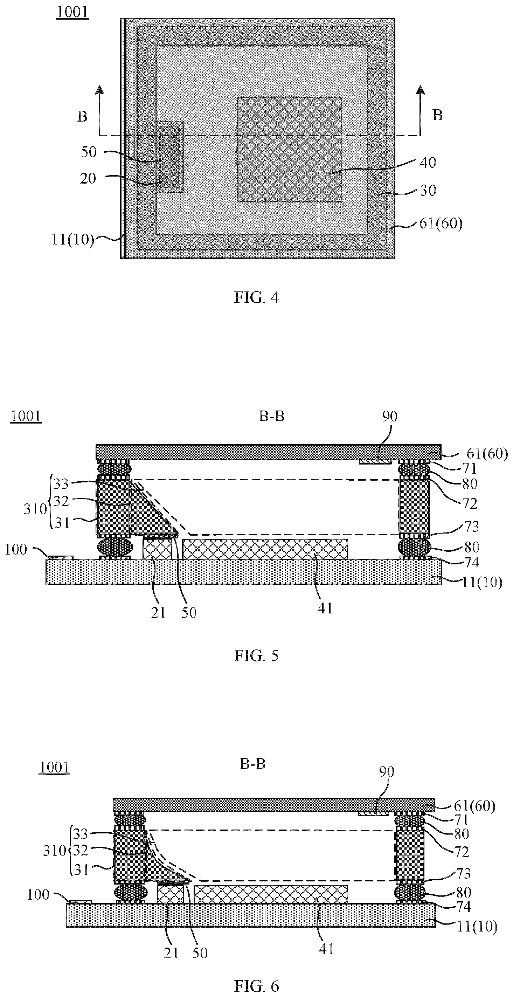

The present disclosure also provides a sensor 1001. As shown in Fig. 4, the sensor 1001 is formed by cutting the wafer-level packaging structure 1000 provided in the above embodiments

As shown in Fig. 5, the sensor 1001 includes a device layer 11, a reference device 21, and a thickened intermediate layer 310. The thickened intermediate layer 310 is obtained by cutting the divided thickened intermediate layer regions 301 of the thickened intermediate layer wafer 30.

The device layer 11 is a substrate that supports a MEMS sensor. Exemplarily, a material of the device layer 11 includes one or more of silicon chip, quartz chip, sapphire, and ceramics. For instance, the material of the device layer 11 includes silicon chip. Exemplarily, a shape of the device layer 11 may be a circular, rectangular, or polygonal substrate. For example, the shape of the device layer 11 is rectangular. The specific configuration may be set according to actual requirements.

The reference device 21 is arranged on the device layer 11 and is configured to output a reference signal.

The thickened intermediate layer 310 is arranged on the device wafer 10. The thickened intermediate layer 310 includes a first sub-portion 31 and a second sub-portion 32 that are connected to each other. The first sub-portion 31 is arranged in a way that it surrounds the reference device 21. In one embodiment, in a direction away from the device wafer 10, a surface of the second sub-portion 32 away from the first sub-portion 31 is inclined towards a side close to the first sub-portion 31. One reference device 21 is arranged in an area enclosed by the first sub-portion 31; and an orthographic projection of the second sub-portion 32 on the device wafer 10 covers the reference device 21.

It should be noted that the second sub-portion 32 of the thickened intermediate layer region 301 is connected to the first sub-portion 31, that is, a connecting surface between the first sub-portion 31 and the second sub-portion 32 is an interface between them. Then, in a direction perpendicular to the device wafer 10, two ends of the second sub-portion 32 can be flush with two ends of the first sub-portion 31 respectively. Herein, a thickness of the interface between the two in a direction parallel to the device wafer 10 is not limited.

The reference device 21 is configured to output reference signal so as to enable the sensor 1001 to judge or calibrate accuracy of actual output signals based on the reference signal, thereby improving performance of the sensor 1001. The orthographic projection of the second sub-portion 32 on the device layer 11 covers the reference device 21. In this way, the second-portion 32 can reduce influence of external electromagnetic waves on a value of the reference signal output by the reference device 21, enhancing accuracy of the reference signal. At the same time, in the direction perpendicular to the device layer 11, the two ends of the second sub-portion 32 are flush with the two ends of the first sub-portion 31 respectively. In the direction away from the device layer 11, the surface of the second sub-portion 32 away from the first sub-portion 31 is inclined towards a side close to the first sub-portion 31, that is, in a direction away from the first sub-portion 31, a thickness of the second sub-portion 32 decreases gradually, reducing shielding effect of the second sub-portion 32 on electromagnetic waves received by other electronic devices located to a side of the reference device 21 away from the first sub-portion 31, and improving the performances of the sensor 1001.

It should be explained that, along the direction perpendicular to the device layer 11, the two ends of the second sub-portion 32 are flush with the two ends of the first sub-portion 31, respectively. This is based on the second sub-portion 32 and the first sub-portion 31 being of an integrated structure, and shapes and dimensions of the connecting interface of the second sub-portion 32 and the first sub-portion 31 are identical. Therefore, the two ends of the second sub-portion 32 are flush with the two ends of the first sub- portion 31, respectively. In the present application, the thickened intermediate layer 310 is divided according to the functions of the first sub-portion 31 and the second sub-portion 32, which does not limit the thickened intermediate layer 310 to only these two parts, nor does it restrict the size relationship between the overall dimensions of the first sub-portion 31 and the second sub-portion 32.

In some examples, the thickened intermediate layer 310 may be a substrate of a same specification (shape and size) as the device layer 11. Exemplarily, the shape of the thickened intermediate layer 310 is basically the same as that of the device layer 11, and may be rectangular. For example, the side length or diameter of the thickened intermediate layer 310 is basically the same as that of the device layer 11, and may be 8 inches, 12 inches or the like. Exemplarily, a thickness of the thickened intermediate layer 310 is in a range of 5µm to 5mm. The thickness of the thickened intermediate layer 310 may be selected and set according to the specification requirements of the packaged MEMS sensors. For instance, the thickness of the thickened intermediate layer 310 is 5µm, 20µm, 100µm, 1mm, or 5mm.

As shown in Figs. 5 to 14, the cross-sectional area of the second sub-portion 32 decreases along the direction away from the first sub-portion 31. The cross-section of the second sub-portion 32 is perpendicular to the device layer 11 and perpendicular to the connecting surface between the first sub-portion 31 and the second sub-portion 32. In this way, the blocking effect of the second sub-portion 32 on other electronic devices located on the side of the reference device 21 away from the first sub-portion 31 in terms of receiving electromagnetic waves is reduced, thereby improving the performance of the wafer-level packaging structure 1000.

It should be noted that considering the manufacturing process of the second sub-portion 32, the orthographic projection of the second sub-portion 32 on the device layer 11 can exactly cover the reference device 21. Alternatively, the second sub-portion 32 is arranged surrounding the reference device 21 (for example, the orthographic projection of the second sub-portion 32 on the device layer 11 is a closed ring or an unclosed ring), and the orthographic projection of a part of the second sub-portion 32 on the device layer 11 covers the reference device 21. The present disclosure does not impose any restrictions on the specific structure of the second sub-portion 32 as long as the orthographic projection of the second sub-portion 32 on the device wafer 10 covers at least the reference device region 20.

Exemplarily, the orthographic projection of the second sub-portion 32 on the device layer 11 can exactly cover the reference device 21. As shown in Fig. 5, the surface of the second sub-portion 32 away from the first sub-portion 31 is inclined towards a side close to the first sub-portion 31. The cross-section of the second sub-portion 32 is a right-angled triangle, and the cross-sectional area decreases along the direction away from the first sub-portion 31, so that external electromagnetic waves can irradiate the functional device 41 along the smooth inclined surface of the second sub-portion 32 away from the first sub-portion 31.

Exemplarily, the orthographic projection of the second sub-portion 32 on the device layer 11 may precisely cover the reference device 21. As shown in Fig. 6, the surface of the second sub-portion 32 away from the first sub-portion 31 is inclined towards a side close to the first sub-portion 31, and the surface of the second sub-portion 32 away from the first sub-portion 31 is concave toward the direction close to the first sub-portion 31. Herein, the cross-sectional area of the second sub-portion 32 away from the functional device 41 is relatively small, which helps ensure that more electromagnetic waves can irradiate the functional device 41.

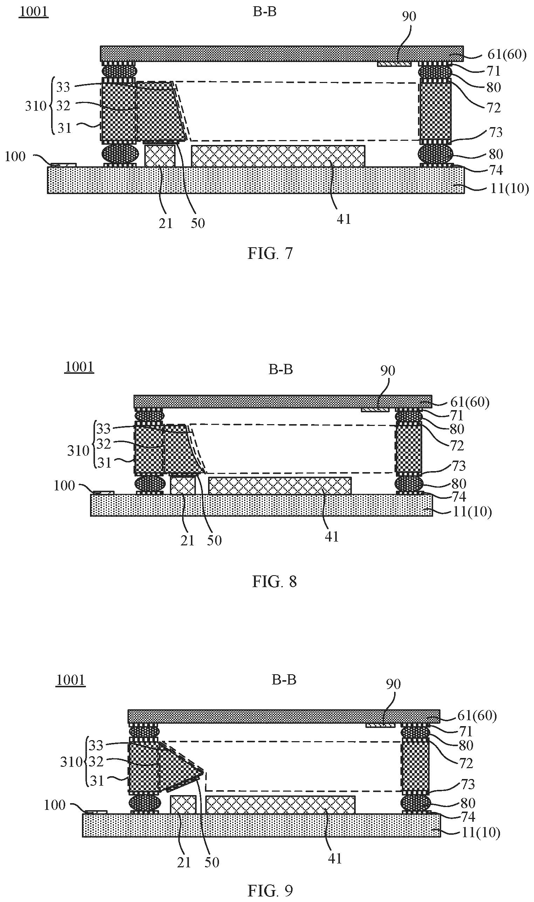

Exemplarily, the orthographic projection of the second sub-portion 32 on the device layer 11 may precisely cover the reference device 21. As shown in Fig. 7, the cross-section of the second sub-portion 32 is a right-angled trapezoid, and its cross-sectional area decreases along the direction away from the first sub-portion 31. In this way, while ensuring the shielding effect on the reference device 21, external electromagnetic waves can irradiate the functional device 41 along the smooth inclined surface of the second sub-portion 32 away from the first sub-portion 31.

Exemplarily, the orthographic projection of the second sub-portion 32 on the device layer 11 may precisely cover the reference device 21. As shown in Fig. 8, along a direction parallel to a plane where the thickened intermediate layer 310 is located, a surface of the second sub-portion 32 away from the device layer 11 has a certain size, and a size of the surface of the second sub-portion 32 away from the device layer 11 is smaller than a size of a surface of the second sub-portion 32 closer to the device layer 11. The surface of the second sub-portion 32 away from the first sub-portion 31 is concave toward the direction close to the first sub-portion 31. The cross-sectional area of the second sub-portion 32 decreases along the direction away from the first sub-portion 31.

In addition, as shown in Fig. 9, the orthographic projection of the second sub-portion 32 on the device layer 11 can exactly cover the reference device 21. The cross-section of the second sub-portion 32 is an acute triangle, and the cross-sectional area decreases in the direction away from the first sub-portion 31. It can be understood that, when the thickness of the thickened intermediate layer 310 is relatively large, or due to limitations of etching process conditions, the thickened intermediate layer 310 can be etched twice, that is, the two opposite surfaces of the thickened intermediate layer 310 are etched respectively, and the cross-section of the formed second sub-portion 32 is an acute triangle.

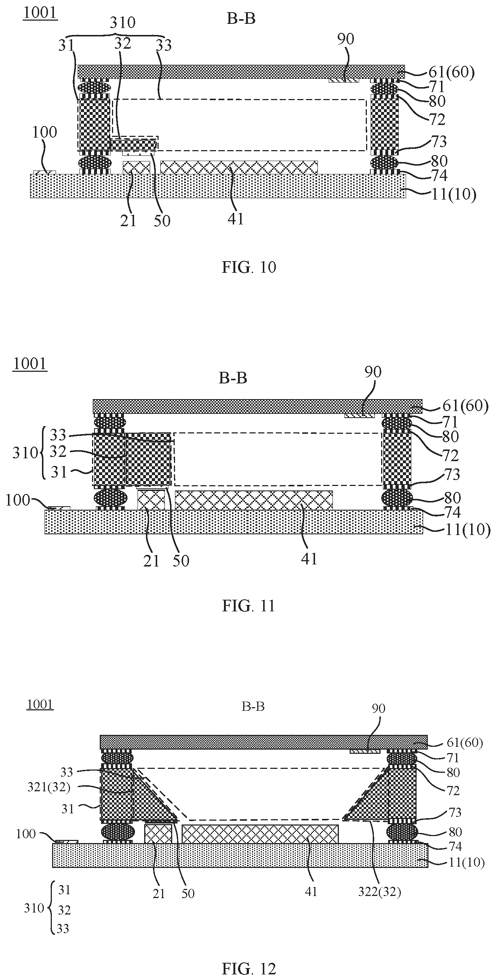

In some embodiments, as shown in Figs. 10-11, the surface of the second sub-portion 32 away from the first sub-portion 31 is stepped; and/or, a plane where the surface of the second sub-portion 32 away from the first sub-portion 31 is located is perpendicular to the device layer 11.

In some embodiments, as shown in Fig. 10, the surface of the second sub-portion 32 away from the first sub-portion 31 is stepped. For example, the surface of the second sub-portion 32 away from the first sub-portion 31 is a single step. It can be understood that the stepped surface can be formed by two etching processes with different degrees. The present disclosure does not impose any restrictions on the etching process steps.

In some embodiments, as shown in Fig. 11, the plane where the surface of the second sub-portion 32 away from the first sub-portion 31 is located is perpendicular to the device layer 11. In this way, a thickness of a part of the second sub-portion 302 whose orthographic projection on the device layer 11 covers the reference device 21 is relatively large, which is beneficial for reducing electromagnetic waves that pass through the part of the second sub-portion 32 and irradiate onto the reference device 21, and reducing the influence of the electromagnetic waves on the accuracy of the reference signal output by the reference device 21.

In some examples, as shown in Figs. 5-8 and Figs. 12-14, the surface of the second sub-portion 32 close to the device layer 11 is connected to the surface of the first sub-portion 31 close to the device layer 11 and both are located in the same plane. In this way, the surface of the second sub-portion 32 close to the device layer 11 is relatively close to the reference device 21, which is beneficial for improving the blocking effect on the electromagnetic waves incident in the direction close to the device layer 11 and irradiating onto the reference device 21.

The angle and connection manner between the plane where the surface of the second sub-portion 32 away from the first sub-portion 31 is located and the plane where the surface of the second sub-portion 32 close to the device layer 11 is located can be selected and set according to actual requirements and process requirements. The present disclosure does not impose any restrictions on this.

Exemplarily, as shown in Fig. 7, a part of the second sub-portion 32 whose orthographic projection on the device layer 11 overlaps with the orthographic projection of the reference device 21 on the device layer 11 has a relatively large thickness, which is beneficial for improving the blocking effect of the second sub-portion 32 on the electromagnetic waves incident in the direction close to the device wafer and should have irradiated onto the reference device 21.

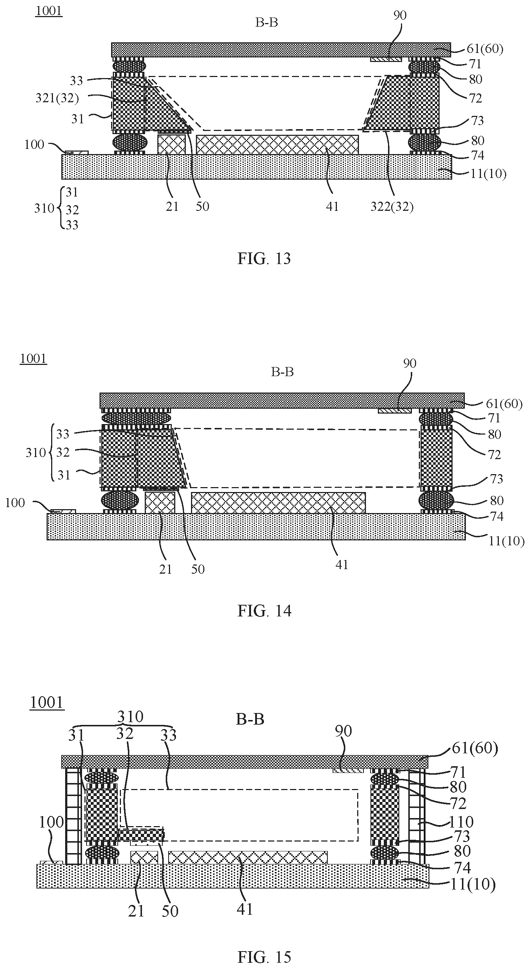

In some examples, as shown in Figs. 12 and 13, the second sub-portion 32 is an annular structure and is arranged surrounding the reference device 21, and the orthographic projection of a part of the second sub-portion 32 on the device layer 11 covers the reference device 21.

Exemplarily, the second sub-portion 32 includes two parts. One part is a shielding portion 321 whose orthographic projection on the device layer 11 covers the reference device 21, and the other part is a non-shielding portion 322. A shape of cross-section of the shielding portion 321 may be the same as or different from that of the non-shielding portion 322, which can be set according to specific requirements and processes.

For example, the orthographic projection of the second sub-portion 32 on the device layer 11 is a closed ring, and the shape of cross-section of the shielding portion 321 of the second sub-portion 32 is the same as that of the non-shielding portion 322. As shown in Fig. 12, the surface of the second sub-portion 32 close to the device layer 11 joins the surface of the first sub-portion 31 close to the device layer 11 and both are located in the same plane. The shape of cross-section of both the shielding portion 321 and the non-shielding portion 322 of the second sub-portion 32 are right triangles.

For another example, the orthographic projection of the second sub-portion 32 on the device layer 11 is a closed ring, and the shape of cross-section of the shielding portion 321 of the second sub-portion 32 is different from that of the non-shielding portion 322. As shown in Fig. 13, the surface of the second sub-portion 32 close to the device layer 11 joins the surface of the first sub-portion 31 close to the device layer 11 and both are located in the same plane. The shape of cross-section of the shielding portion 321 is a right triangle while the shape of cross-section of the non-shielding portion 322 is a right trapezoid.

In some examples, as shown in Figs. 5-14, the sensor 1001 further includes a functional device 41. The functional device 41 is arranged in the area surrounded by the first sub-portion 31 and is configured to output a sensing signal. That is, the first sub-portion 31 encloses the reference device 21 and the functional device 41 in the same area. The orthographic projection of the second sub-portion 32 on the device layer 11 covers the reference device 21, and the orthographic projection of the second sub-portion 32 on the device layer 11 does not overlap with the functional device 41. External electromagnetic waves irradiate onto the functional device 41 along the inclined surface of the second sub-portion 32 away from the first sub-portion 31. The inclination degree of the surface of the second sub-portion 32 away from the first sub-portion 31 can be set according to requirements, so as to increase the electromagnetic waves irradiating onto the functional device 41 and improve the sensing effect of the functional device 41. For example, the inclination degree of the surface of the second sub-portion 32 away from the first sub-portion 31 can be set according to the distance and relative position relationship between the functional device 41 and the second sub-portion 32. The present disclosure does not impose any restrictions on this.

Please continue to refer to Figs. 5-14, the thickened intermediate layer 310 has a via hole 33. Wall of the via hole 33 is the surface of the second sub-portion 32 away from the first sub-portion 31, and a shape of the cross-section of the via hole 33 is related to the shape of cross-section of the second sub-portion 32. A shape enclosed by a boundary of an orthographic projection of the via hole 33 on the device layer 11 can be any one or more of a rectangle, a circle, and a polygon, and can be set according to the positions, shapes, and sizes of the reference device 21 and the functional device 41, as long as it is ensured that only the functional device 40 is exposed by the via hole 33.

The wall of the via hole 33 is the surface of the second sub-portion 32 away from the first sub-portion 31, that is, the boundary of the orthographic projection of the via hole 33 on the device layer 11 surrounds the functional device 41. In this way, only the functional device 41 is exposed by the via hole 33, which is convenient for the functional device 41 to obtain the electromagnetic waves transmitted through the via hole 33, and output a sensing signal. Moreover, the reference device 21 shielded by the second sub-portion 32 can output a reference signal that is not affected by external electromagnetic waves. In this way, during the subsequent signal judgment process, by comparing the sensing signal with the reference signal, it is convenient to eliminate the influence of the resistance of the functional device 41 itself on the magnitude of the output signal. In addition, an opening of the via hole 33 away from the functional device region 40 is larger than an opening of the via hole 33 close to the functional device region 40. In this way, the opening on the side of the thickened intermediate layer 310 away from the functional device 41 is relatively large. Since the electromagnetic waves do not irradiate the functional device 41 vertically, more electromagnetic waves will pass through the opening of the via hole 33 away from the device wafer 10 to irradiate the functional device 41, which is beneficial for improving the sensing effect of the functional device 41.

Exemplarily, the functional device 41 is a MEMS sensor, which may include one or more of MEMS devices such as a gyroscope, an accelerometer, a pressure gauge, and an infrared focal plane array. For example, the functional device 41 includes an infrared focal plane array.

In some examples, as shown in Fig. 4, the wafer-level packaging structure 1000 further includes a blocking layer 50. The blocking layer 50 is arranged on the side of the second sub-portion 32 close to the reference device 21 and is connected to the second sub-portion 32. An orthographic projection of the blocking layer 50 on the device layer 11 covers the reference device 21 and the blocking layer 50 is configured to block electromagnetic waves from irradiating onto the reference device 21. The blocking layer 50 can further reduce the influence of external electromagnetic waves on the magnitude of the reference signal output by the reference device 21, and improve the accuracy of the actual output signal of the wafer-level packaging structure 1000.

Exemplarily, a material of the blocking layer 50 includes a metal or other materials that can effectively block electromagnetic waves. For example, the material of the blocking layer 50 includes one or more of titanium, zirconium alloy, titanium alloy, gold, platinum, chromium, and nickel. For instance, the material of the blocking layer 50 includes a titanium alloy.

In some examples, as shown in Figs. 4-12, the sensor 1001 further includes a capping layer 61, a first sealing member 71, a second sealing member 72, a third sealing member 73, and a fourth sealing member 74.

The capping layer 61 is arranged on the side of the thickened intermediate layer 310 away from the device layer 11. For example, the capping layer 61 is made of one or more of substrate materials such as silicon chip, germanium chip, and glass. For instance, the capping layer 61 is a silicon chip. It should be noted that in the embodiments of the present disclosure, the part of the thickened intermediate layer 310 used to support the device wafer and the capping layer 61 is regarded as the first sub-portion 31, and remaining part that is on the side of the first sub-portion 31 close to the reference device 21 is regarded as the second sub-portion 32, which is convenient for describing the shapes and functions of each part of the thickened intermediate layer 310. However, the embodiments of the present disclosure do not limit the shapes and sizes of other parts of the thickened intermediate layer 310. A via hole 33 that penetrates the thickened intermediate layer 310 is etched in the thickened intermediate layer 310. The thickened intermediate layer 310, the capping layer 61, and the device layer 11 jointly form a sealed cavity for the MEMS sensor (the functional device 41 and the reference device 21), and a height of the sealed cavity is mainly determined by a thickness of the thickened intermediate layer 310. The thickness of the thickened intermediate layer 310 is related to the specifications of the MEMS sensor, so as to reduce influence of particulate impurities in the sealed cavity on the performance of the MEMS sensor and improve isolation tolerance of the sensor 1001.

For example, an infrared anti-reflection coating is provided on the side of the capping layer 61 away from the device layer 11 or close to the device layer 11. A material of the infrared anti-reflection coating includes one or more of zinc sulfide, germanium, and zinc selenide. The infrared anti-reflection coating is configured to increase transmittance of infrared rays, so as to increase the amount of light of infrared rays irradiating onto the functional device 41 and improve the sensing effect of the functional device 41.

The first sealing member 71 is arranged on the side of the capping layer 61 close to the device layer 11 and is connected to the capping layer 61.

The second sealing member 72 is arranged on the side of the thickened intermediate layer 310 close to the capping layer 61 and is connected to the thickened intermediate layer 310.

The third sealing member 73 is arranged on the side of the thickened intermediate layer 310 away from the capping layer 61 and is connected to the thickened intermediate layer 310.

The fourth sealing member 74 is arranged on the side of the device layer 11 close to the capping layer 61 and is connected to the device layer 11.

The first sealing member 71 and the second sealing member 72 are connected by solder 80; the third sealing member 73 and the fourth sealing member 74 are connected by solder 80.

For example, materials of the first sealing member 71, the second sealing member 72, the third sealing member 73, and the fourth sealing member 74 include composite materials such as Cr/Au, Cr/Ni/Au, or Ti/Pt/Au. The materials of the first sealing member 71, the second sealing member 72, the third sealing member 73, and the fourth sealing member 74 may be the same or different.

For example, the materials used for the first sealing member 71, the second sealing member 72, the third sealing member 73, and the fourth sealing member 74 are the same, and all are a three-layer composite material of Cr/Ni/Au. These sealing members include a bottom layer, a middle layer, and a top layer. The top layer is a wetting layer for contacting the solder, and the material Au is used, which is convenient for realizing eutectic soldering with the solder. The bottom layer is an adhesion layer in contact with the substrate (the device layer 11, the thickened intermediate layer 310, and the capping layer 61), and the material Cr is used, which is convenient for realizing adhesion with the middle layer. The middle layer is a barrier layer, and the material Ni is used to prevent metal in the top layer from diffusing into the substrate.

Exemplarily, the solder 80 can be various alloy solders, such as Sn-based solders, Sn-In, Sn-Ag, Sn-Au, Sn-Ag-Cu and the like, which can be selected according to the materials of the composite sealing members.

In some examples, there is a gap between the area within the cavity and surrounded by extending edges of the functional device 41 in the direction perpendicular to the device wafer 10 and the surface of the second sub-portion 32 away from the first sub-portion 31. In this way, while ensuring that electromagnetic waves incident in the direction perpendicular to the device wafer 10 irradiate the functional device 41, there are still at least some electromagnetic waves that are not blocked by the second sub-portion 33 within the cavity and can irradiate the functional device 41, thereby improving the effect of the functional device 41 in sensing the electromagnetic waves.

In some examples, as shown in Fig. 14, the cross-section of the second sub-portion 32 is a right trapezoid. Moreover, a size of a part of the second sealing member 72 on the surface of the second sub-portion 32 away from the device layer 11 is relatively large, which is beneficial for improving bonding stability between the thickened intermediate layer 310 and the capping layer 61. At the same time, since there are a large number of film layers between the capping layer 61 and the reference device 21, the electromagnetic waves incident from the capping layer 61 will pass through the second sealing member 72, the second sub-portion 32, and the blocking layer and irradiate onto the reference device 21. In this way, it further reduces the influence of the incident electromagnetic waves on the accuracy of the reference signal output by the reference device 21, which is beneficial for improving the performance of the wafer-level packaging structure 1000.

In some examples, as shown in Figs. 4-14, the sensor 1001 further includes a getter 90. In this way, in the sealed cavity of the MEMS sensor (the functional device 41 and the reference device 21) jointly formed by the thickened intermediate layer 310, the capping layer 61, and the device layer 11, the getter 90 can absorb residual gas in the sealed cavity and exhaust gas generated during operation of the MEMS sensor, improving the quality of vacuum environment in the sealed cavity, which is beneficial for increasing service life of the MEMS sensor. For example, the getter 90 can be a non-evaporable getter, such as one or more of titanium, zirconium alloy, and titanium alloy. For instance, the getter 90 includes a titanium alloy.

An orthographic projection of the getter 90 on the device layer 11 does not overlap with the orthographic projection of the functional device 41 on the device layer 11; and/or, the blocking layer 50 includes the getter 90.

Exemplarily, the orthographic projection of the getter 90 on the device layer 11 can at least partially overlap with the orthographic projection of the blocking layer 50 on the device layer 11, and does not overlap with the orthographic projection of the functional device 41 on the device layer 11.

Alternatively, since the materials used for the getter 90 include elemental metal or alloys that can achieve the effect of blocking electromagnetic waves, based on the function of the blocking layer 50, the material of the blocking layer 50 can be the same as that of the getter 90, or the blocking layer 50 includes the getter 90. In this way, the blocking layer 50 can be made of the same material and through the same manufacturing process as the getter 90, reducing the process steps in the entire manufacturing process of the sensor 1001.

It can be understood that, as shown in Figs. 4-14, the sensor 1001 further includes a plurality of wire bonding windows 100. The wire bonding windows 100 are arranged on the device layer 11. Moreover, each sensor 1001 has a plurality of wire bonding windows 100. The plurality of wire bonding windows 100 are arranged on a side of the first sub-portion 31 away from the via hole 33, and are electrically connected to the reference device 21 and the functional device 41, and are configured to transmit the reference signal output by the reference device 21 and the sensing signal output by the functional device 41 to a circuit electrically connected to each sensor 1001.

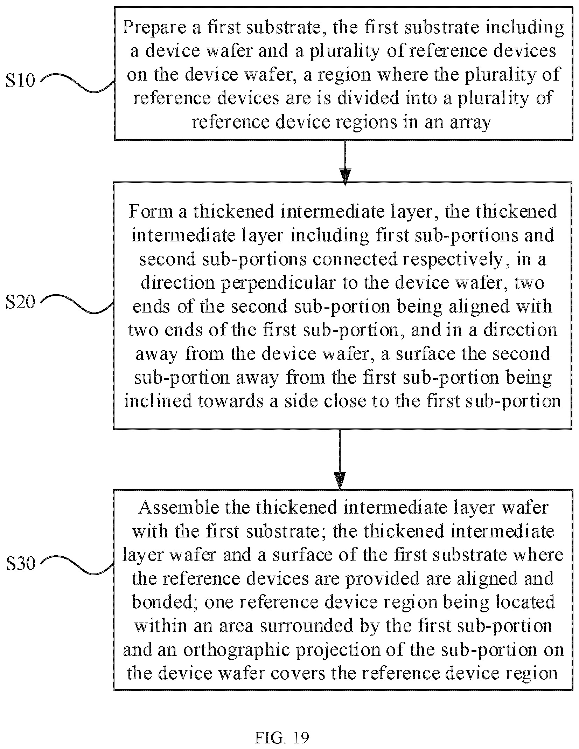

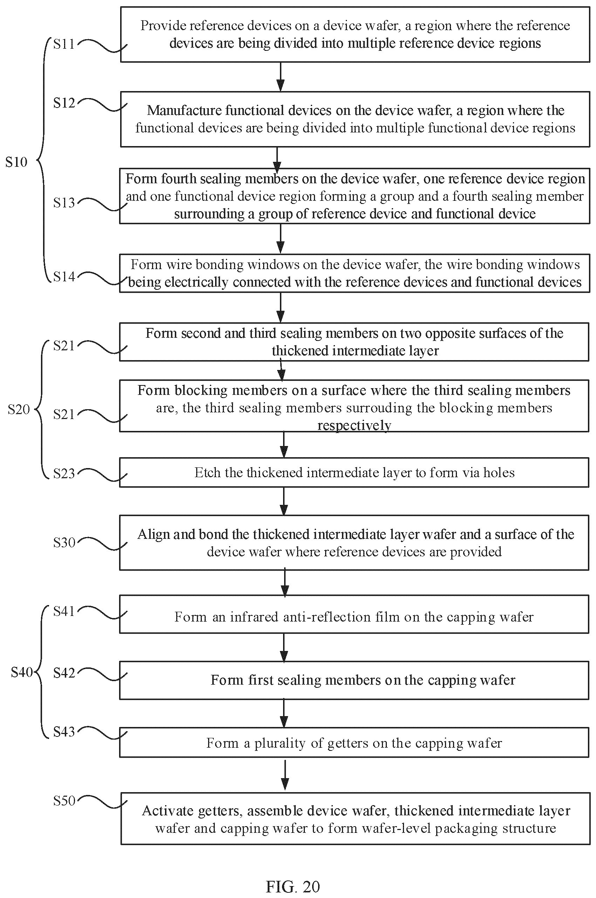

The present disclosure also provides a manufacturing method of a wafer-level packaging structure. As shown in Fig. 4, Fig. 19 and Fig. 20, the manufacturing method of the wafer-level packaging structure 1000 includes: S10~S50.

S10: Prepare a device wafer 10. The device wafer 10 has a plurality of reference device regions 20; and one or more reference devices 21 are provided in each reference device region 20.

For example, the plurality of reference device regions 20 are arranged in an array, and one reference device is provided in each reference device region 20.

Preparing the device wafer 10 includes S11~S14.

S11: Provide reference devices 21 on the device wafer 10. The reference devices 21 are configured to output reference signals.

S12: Arrange a plurality of functional device regions 40 on the device wafer 10. One or more functional devices 41 are provided in each functional device region 40. The functional device 41 is configured to output a sensing signal. External electromagnetic waves irradiate the functional device 41 along an inclined surface of the second sub-portion 32 away from the first sub-portion 31.

Moreover, there is a gap between the functional device region 40 and the reference device region 20. And the functional device region 40 is located within a boundary of an orthographic projection of a via hole on the device wafer 41.

Generally, a size of the reference device 21 is smaller than that of the functional device 41, as long as the reference device 21 can output a valid reference signal. The reference device 21 can be located on any side of the functional device 41. The present disclosure does not specifically limit the specifications of the reference device 21. Exemplarily, the functional device 41 includes an infrared focal plane array. The reference device 21 has the same working principle as the functional device 41 and outputs the same type of electrical signal.

S13: Form fourth sealing members 74 on the device wafer 10. One reference device region 20 and one functional device region 40 form a group, and a fourth sealing member 74 surrounds a group of the reference device region 20 and the functional device region 40. The fourth sealing member 74 is a three-layer composite structure including a bottom layer, a middle layer, and a top layer. The top layer is a wetting layer for contacting a solder, using a material of Au, which facilitates eutectic soldering with the solder. The bottom layer is an adhesion layer in contact with the substrate (the device wafer 10, the thickened intermediate layer wafer 30, and the capping wafer 60), using a material of Cr, which facilitates adhesion with the middle layer. The middle layer is a barrier layer, using a material of Ni to prevent metal of the top-layer from diffusing into the substrate. In this way, the materials Cr, Ni, and Au are sequentially deposited on the device wafer and then patterned using a photolithography process to form the fourth sealing members 74.

It should be noted that in subsequent processes, the first sealing members 71, the second sealing members 72, and the third sealing members 73 can be formed using the same materials and the same process as the fourth sealing members 74. This will not be repeated in the subsequent embodiments of the present disclosure. The deposition process includes methods such as thermal evaporation and sputtering, which can be set according to actual needs in the present disclosure.

S14: Form a plurality of wire-bonding windows 100 on the device wafer 10. The wire-bonding windows 100 are electrically connected to the reference devices 21 and the functional devices 41 and are configured to transmit the reference signals output by the reference devices 21 and the sensing signals output by the functional devices 41 to a circuit electrically connected to each sensor 1001. The wire-bonding window is located on the side of the fourth sealing member 74 away from the reference device 21. The wire-bonding window 100 includes multiple pads, and the number of pads can be set according to the actual number of signal lines.

S20: Prepare a thickened intermediate layer wafer 30. The thickened intermediate layer wafer includes multiple thickened intermediate layer regions 301. Each thickened intermediate layer region 301 includes a first sub-portion 31 and a second sub-portion 32 that are connected. Along the direction away from the device wafer 10, a surface of the second sub-portion 32 away from the first sub-portion 31 is inclined towards a side close to the first sub-portion 31. Along a direction perpendicular to the device wafer 10, two ends of the second sub-portion 32 are flush with two ends of the first sub-portion 31 respectively.

S20 includes S21~S23.

S21: second sealing members 72 and third sealing members 73 are formed on two opposite sides of the thickened intermediate layer wafer 30.

S22: blocking layers 50 are formed on a surface where the third sealing members 73 are located; each third sealing member 73 surrounding a blocking layer 50.

A material of the blocking layers 50 is deposited on a surface of the thickened intermediate layer wafer 30 on which the third sealing members 73 are formed, then photoresist is coated and photolithographic process is performed to form the blocking layers 50.

The material of the blocking layers 50 includes metals or other materials that can effectively block electromagnetic waves. For example, the material of the blocking layers 50 includes one or more of titanium, zirconium alloy, titanium alloy, gold, platinum, chromium, and nickel. For instance, the material of the blocking layers 50 includes a titanium alloy.

In addition, the blocking layers 50 can also be formed synchronously with the third sealing members 73. For example, while patterning the three-layer material stack of the third sealing members 73, a pattern of the blocking layers 50 is formed by etching.

S23: Etch the thickened intermediate layer wafer 30 to form a plurality of via holes 33. Wall of a via hole 33 is the surface of the second sub-portion 32 away from the first sub-portion 31.

A shape enclosed by a boundary of an orthographic projection of the via hole 33 on the device wafer 10 can be any one or more of a rectangle, a circle, and a polygon, and can be selected and set according to the shape of the functional device 41. A dry etching or wet etching process can be used to etch the thickened intermediate layer wafer 30 and form the via holes 33. For example, the etching process can adopt wet etching, in which the thickened intermediate layer wafer 30 to be etched is placed in an etching solution with a determined chemical composition and a fixed temperature for etching. The etching solution has different etching rates for different crystal planes of the thickened intermediate layer wafer 30, and required shielding structures (that is, the shielding portions 321 of the second sub-portions 32) can be fabricated on the thickened intermediate layer wafer 30.

S30: Align and bond the thickened intermediate layer wafer 30 with the surface of the device wafer 10 where the reference devices 21 are provided. The fourth sealing members 74 and the third sealing members 73 of the thickened intermediate layer wafer 30 are bonded by solder 80. For example, the solder 80 is formed on the fourth sealing members 74 through an evaporation, electroplating, or screen printing process, and a vacuum bonding device (for example, a wafer bonder) is used to bond the thickened intermediate layer wafer 30 and a first substrate together.

For example, after the thickened intermediate layer wafer 30 is aligned with the device wafer 10, orthographic projections of the second sub-portions 32 on the device wafer 10 cover the reference devices 21, and orthographic projections of the blocking layers 50 on the device wafer 10 cover the reference device 21. Moreover, the functional devices 41 are located within boundaries of the orthographic projections of the via holes 33 on the device wafer 10. In this way, the blocking layers 50 can reduce influence of electromagnetic waves incident onto the wafer-level packaging structure 1000 on the reference devices 21, and structures of various parts of the thickened intermediate layer wafer 30 do not affect the sensing effect of the functional devices 41 for electromagnetic waves. Orthographic projections of openings of the via holes 33 in the surface of the thickened intermediate layer wafer 30 away from the device wafer 10 on the device wafer 10 cover orthographic projections of the openings of the via holes 33 in the surface of the thickened intermediate layer wafer 30 close to the device wafer 10 on the device wafer 10.

S40: prepare a capping wafer 60.

S40 includes S41~S43.

S41: Form an infrared anti-reflection coating on the capping wafer 60. Using an evaporation process, coat one or more materials such as zinc sulfide, germanium, and zinc selenide on at least one surface of the capping wafer 60 to grow and form the infrared anti-reflection coating. The infrared anti-reflection coating is configured to increase transmittance of infrared rays, so as to increase the amount of infrared light irradiating onto the functional devices 41 and improve the sensing effect of the functional devices 41.

S42: Form first sealing members 71 on the capping wafer 60. The manufacturing process and material of the first sealing members 71 are the same as those of the fourth sealing members 74, and will not be described in detail here.

S43: Form getters 90 on the capping wafer 60.

For example, the getters 90 can be non-evaporable, such as one or more of titanium, zirconium alloy, and titanium alloy. For instance, the getter 90 includes a titanium alloy. Use a deposition process to sputter a titanium alloy material on the capping wafer 60, and form patterned getters 90 through a photolithography process. The getters 90 can also be synchronously fabricated with the first sealing members 71 using the same material.

S50: Based on the wafer-level packaging structure 1000 formed after the assembly of the device wafer 10, the thickened intermediate layer wafer 30, and the capping wafer 60, activate the getters 90.

The first sealing members 71 and the second sealing members 72 of the thickened intermediate layer wafer 30 are bonded by solder 80. For example, the solder 80 is formed on the second sealing members 72 through an evaporation, electroplating, or screen printing process, and a vacuum bonding device (for example, a wafer bonder) is used to bond the assembled device wafer 10, thickened intermediate layer wafer 30, and capping wafer 60 together.

Orthographic projections of the getters 90 on the device wafer 10 do not overlap with the orthographic projections of the functional devices 41 on the device wafer 10.

An activation temperature of the getters 90 can be determined according to the material of the getters 90 and actual application of the device. For example, the activation temperature is approximately 400°C. In sealed cavities formed by the device wafer 10, the thickened intermediate layer wafer 30, and the capping wafer 60, the activated getters 90 can absorb residual gas and exhaust gas generated during the operation of the MEMS sensor in the sealed cavities, improving the quality of vacuum environment in the sealed cavities, which is beneficial for increasing service life of the MEMS sensors.

It can be understood that, based on the structure of the thickened intermediate layer wafer 20 that has been prepared above, a process sequence in which the above-mentioned device wafer 10, thickened intermediate layer wafer 30, and capping wafer 60 are assembled to form the wafer-level packaging structure 1000 can be that after the device wafer 10 is assembled and aligned with the thickened intermediate layer wafer 30, the capping wafer 60 is assembled and aligned therewith; alternatively can also be that after the capping wafer 60 is assembled and aligned with the thickened intermediate layer wafer 30, the device wafer 10 is then assembled and aligned therewith; alternatively can also be that the device wafer 10, the thickened intermediate layer wafer 30, and the capping wafer 60 are placed in a same installation space and are aligned and assembled simultaneously. The present disclosure does not limit the bonding sequence of assembling the device wafer 10, the thickened intermediate layer wafer 30, and the capping wafer 60, which can be set according to the actual assembly scenario.

In addition, for the wafer-level packaging structure 1000 formed by the above process steps, in the case of needing dicing, a dicing saw is used to cut it into multiple individual packaging structures 1001 (i.e., sensors 1001) for application in various electronic devices.

In some embodiments, as shown in Figs. 15-18, the sensor 1001 further includes at least one buffer member 110. The at least one buffer member 110 is located between the device layer 11 and the capping layer 61, with one end connected to the device layer 11 and the other end connected to the capping layer 61.

The material used for the buffer member 110 has a certain strength and plasticity. It can be understood that during the process of bonding the sealing members and the solder 80 to package the device layer 11, the thickened intermediate layer wafer 30, and the capping layer 61, the solder is in a molten state and cannot bear force. The buffer member 110 can provide a basic gap for the solder 80. In this way, if there is too little solder 80 in the gap between the first sealing member 71 and the second sealing member 72 (as well as the third sealing member 73 and the fourth sealing member 74), the sensor 1001 may leak air or even have a reduced service life; if there is too much solder 80 in the gap, consequently the solder 80 will overflow into the MEMS sensor or out to the wire bonding windows 100, resulting in the MEMS sensor being unable to transmit signals normally and causing the sensor 1001 to be scrapped. Therefore, using the buffer member 110 is beneficial for improving the packaging effect and product yield of the sensors 1001.

It can be understood that a height of the buffer member 110 is related to the volume of the solder 80 or the thickness of the thickened intermediate layer wafer 30, and can be set according to the actual situation.

In some examples, as shown in Fig. 15, the at least one buffer member 110 includes a single buffer member 110. This buffer member 110 has an annular structure and is arranged along the edge surrounding the entire sensor 1001. This annular buffer member 110 can provide a gap that maintains a certain distance between the device layer 11 and the capping layer 61.

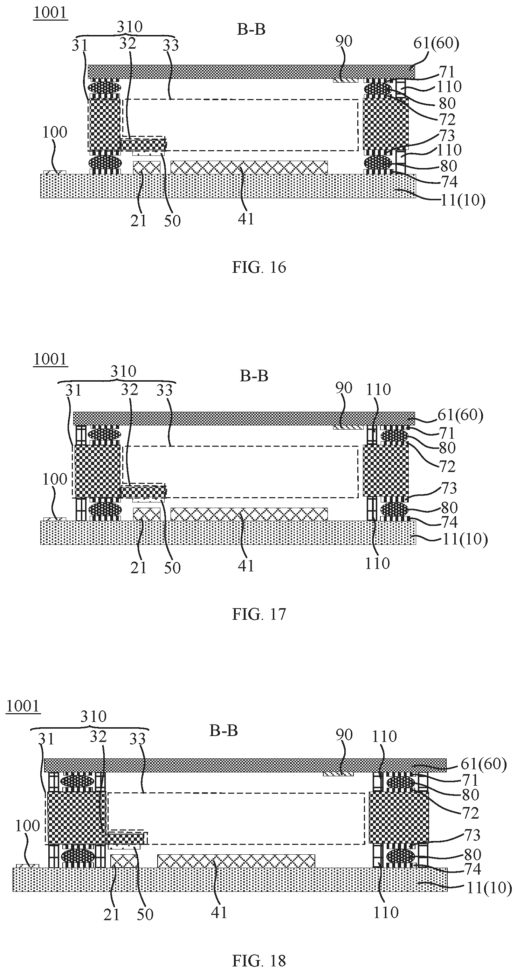

In some examples, as shown in Fig. 16, the at least one buffer member 110 includes at least two buffer members 110. At least one of the at least two buffer members 110 is located between the device layer 11 and the thickened intermediate layer 310, with one end connected to the device layer 11 and the other end connected to the thickened intermediate layer 310; and at least one of the at least two buffer members 110 is located between the capping layer 61 and the thickened intermediate layer 310, with one end connected to the capping layer 61 and the other end connected to the thickened intermediate layer 310.

Exemplarily, as shown in Fig. 17, in the case where the wafer-level packaging structure 1000 includes a plurality of individual sensors 1001 arranged in a 3×3 array, each sensor 1001 includes two buffer members 110 which have an annular structure respectively. The wafer-level packaging structure 1000 includes 18 buffer members 110.

In each sensor 1001, one buffer member 110 is located between the device layer 11 and the thickened intermediate layer 310, with one end connected to the device layer 11 and the other end connected to the thickened intermediate layer 310. A part of this buffer member 110 is located between the wire bonding window 100 and the sealing member; another part is located between the functional device 41 and the sealing member.

The other buffer member 110 is located between the capping layer 61 and the thickened intermediate layer 310, with one end connected to the capping layer 61 and the other end connected to the thickened intermediate layer 310. A part of this buffer member 110 is located between the wire bonding window 100 and the sealing member; another part is located between the functional device 41 and the sealing member, and is also located between the getter 90 and the sealing member. In this way, it can prevent the solder 80 from overflowing into the functional device 41 and from overflowing out to the wire bonding window 100. At the same time, gas absorption effect of the getter 90 for the cavity is not affected, improving the packaging effect and product yield of the sensor 1001.

Exemplarily, as shown in Fig. 18, in the case where the wafer-level packaging structure 1000 includes a plurality of sensors 1001 arranged in a 3×3 array, each sensor 1001 includes four buffer members 110. The wafer-level packaging structure 1000 includes 36 buffer members 110.

In each sensor 1001, the buffer members each 110 have an annular structure, and two buffer members 110 are nested. One group of them is arranged between the device layer 11 and the thickened intermediate layer 310, and one end of this group of buffer members 110 is connected to the device layer 11, and the other end is connected to the thickened intermediate layer 310. One buffer member 110 in this group is located on the side of the sealing member away from the functional device 41, and the other buffer member 110 is located on the side of the sealing member close to the functional device 41.

Similarly, other group is arranged between the capping layer 61 and the thickened intermediate layer 310, and one end of this group of buffer members 110 is connected to the capping layer 61, and the other end is connected to the thickened intermediate layer 310. One buffer member 110 in this group is located on the side of the sealing member away from the functional device 41; the other buffer member 110 is located on the side of the sealing member close to the functional device 41 and is located between the getter 90 and the sealing member. In this way, the solder 80 can be prevented from overflowing into the functional device 41 or the reference device 21, as well as from overflowing out to the wire bonding window 100. At the same time, gas absorption effect of the getter 90 for the sealed cavity is not affected, improving the packaging effect and product yield of the sensor 1001.

It is to be understood that a placement of the buffer members 110 can be adjusted according to the actual packaging structure, which is not limited herein.

In the aforementioned embodiments, the descriptions of each embodiment have their own emphasis. For parts not detailed in a particular embodiment, reference can be made to the relevant descriptions in other embodiments.

Although the present disclosure has been described in conjunction with specific features and their embodiments, it is obvious that various modifications and combinations can be made without departing from the spirit and scope of the present disclosure. Accordingly, the specification and drawings are merely illustrative of the application as defined by the appended claims and are considered to cover any and all modifications, variations, combinations, or equivalents within the scope of the present disclosure. Clearly, those skilled in the art can make various modifications and variations to the present disclosure without departing from its spirit and scope. Thus, if these modifications and variations of the application fall within the scope of the claims and their equivalent technologies, the present disclosure is also intended to include such modifications and variations.

## Claims

1. A wafer-level packaging structure, comprising:
a device wafer;
a plurality of reference device regions disposed on the device wafer and each configured to provide a reference device; and
a thickened intermediate layer wafer, arranged on the device wafer; wherein the thickened intermediate layer wafer comprises a plurality of thickened intermediate layer regions, and the thickened intermediate layer regions each comprise a first sub-portion and a second sub-portion that are connected to each other; wherein one reference device region of the reference device regions is arranged within an area surrounded by the first sub-portion; and an orthographic projection of the second sub-portion on the device wafer covers the reference device region.

2. The wafer-level packaging structure according to claim 1, wherein,
in a direction away from the device wafer, a surface of the second sub-portion away from the first sub-portion is inclined towards a side close to the first sub-portion; and/or,
the surface of the second sub-portion away from the first sub-portion is stepped; and/or,
a plane where the surface of the second sub-portion away from the first sub-portion is located is perpendicular to a device layer.

3. The wafer-level packaging structure according to claim 1, wherein the wafer-level packaging structure further comprises a plurality of functional device regions; each functional device region of the functional device regions is arranged within an area surrounded by the first sub-portion and configured to provide a functional device and output a sensing signal; and
in a direction perpendicular to the device wafer, both ends of the second sub-portion are flush with both ends of the first sub-portion respectively; and the orthographic projection of the second sub-portion on the device wafer does not overlap with the functional device region.

4. The wafer-level packaging structure according to claim 3, wherein each of the thickened intermediate layer regions has a via hole; an opening of the via hole away from the functional device is larger than an opening of the via hole close to the functional device;
a boundary of an orthographic projection of the via hole on the device wafer surrounds the functional device region; and
in a direction away from the device wafer, an area of a cross-section of the via hole increases.

5. The wafer-level packaging structure according to claim 4, wherein each of the thickened intermediate layer regions further comprises:
at least one blocking layer, arranged on a side of the second sub-portion close to the reference device region and connected to the second sub-portion; and
an orthographic projection of the blocking layer on the device wafer covers the reference device region, and the at least one blocking layer is configured to block electromagnetic waves from irradiating the reference device.

6. The wafer-level packaging structure according to claim 5, wherein each of the thickened intermediate layer regions further comprises at least one getter;
an orthographic projection of the at least one getter on the device wafer does not overlap with an orthographic projection of the functional device region on the device wafer; and/or,
the blocking layer comprises the getter.

7. The wafer-level packaging structure according to claim 3, wherein the wafer-level packaging structure further comprises:
a capping wafer, arranged on a side of the thickened intermediate layer wafer away from the device wafer;
the capping wafer, the plurality of thickened intermediate layer regions and the device wafer enclose a plurality of sealed cavities; and
one reference device region of the reference device regions and one functional device region of the functional device regions form a group; at least one group of the functional device region and the reference device region is located within one of the cavities.

8. The wafer-level packaging structure according to claim 7, wherein there is a gap between an area within the cavity and formed by extending edges of the functional device region in a direction perpendicular to the device wafer and a surface of the second sub-portion away from the first sub-portion.

9. The wafer-level packaging structure according to claim 7, wherein the wafer-level packaging structure further comprises at least one buffer member;
the at least one buffer member is located between the device wafer and the capping wafer, with one end connected to the device wafer and other end connected to the capping wafer.

10. A sensor, comprising:
a device layer;
a reference device, arranged on the device layer;
a thickened intermediate layer, arranged on the device layer and comprising a first sub-portion and a second sub-portion that are connected to each other; wherein the reference device is arranged within an area surrounded by the first sub-portion; and an orthographic projection of the second sub-portion on the device layer covers the reference device.

11. The sensor according to claim 10, wherein,
in a direction away from the device layer, a surface of the second sub-portion away from the first sub-portion is inclined towards a side close to the first sub-portion; and/or,
the surface of the second sub-portion away from the first sub-portion is stepped; and/or,
a plane where the surface of the second sub-portion away from the first sub-portion is located is perpendicular to the device layer.

12. The sensor according to claim 10, wherein
a shape of a cross-section of the second sub-portion is a right triangle or a right trapezoid; the cross-section is perpendicular to the device layer and perpendicular to a connecting surface of the first sub-portion and the second sub-portion; and
a surface of the second sub-portion close to the device layer is connected to a surface of the first sub-portion close to the device layer and both are located in a same plane.

13. The sensor according to claim 12, wherein the sensor further comprises a functional device; the functional device is arranged within the area surrounded by the first sub-portion, and configured to output a sensing signal;
in a direction perpendicular to the device wafer, both ends of the second sub-portion are flush with both ends of the first sub-portion respectively; and the orthographic projection of the second sub-portion on the device layer does not overlap with the functional device.

14. The sensor according to claim 13, wherein the thickened intermediate layer has a via hole, a boundary of an orthographic projection of the via hole on the device wafer surrounds the functional device;
an opening of the via hole away from the functional device is larger than an opening of the via hole close to the functional device; and
in a direction away from the device layer, an area of a cross-section of the via hole increases.

15. The sensor according to claim 13, wherein the sensor further comprises:
a blocking layer, arranged on a side of the second sub-portion close to the reference device and connected to the second sub-portion; and
an orthographic projection of the blocking layer on the device layer covers the reference device, and the blocking layer is configured to block electromagnetic waves from irradiating the reference device.

16. The sensor according to claim 15, wherein the sensor further comprises a getter;
an orthographic projection of the getter on the device layer does not overlap with an orthographic projection of the functional device on the device layer; and/or,
the blocking layer comprises the getter.

17. The sensor according to claim 10, wherein the sensor further comprises:
a capping layer, arranged on a side of the thickened intermediate layer away from the device layer; and
a functional device,
wherein the capping layer, the thickened intermediate layer and the device layer enclose a sealed cavity, and the functional device and the reference device are located within the cavity.

18. The sensor according to claim 17, wherein there is a gap between an area within the cavity and formed by extending edges of the functional device in a direction perpendicular to the device wafer and a surface of the second sub-portion away from the first sub-portion.

19. The sensor according to claim 17, wherein the sensor further comprises at least one buffer member, and the at least one buffer member comprises at least two buffer members; and
at least one of the at least two buffer members is located between the device layer and the thickened intermediate layer with one end connected to the device layer and other end connected to the thickened intermediate layer; and at least one of the at least two buffer members is located between the capping layer and the thickened intermediate layer with one end connected to the capping layer and other end connected to the thickened intermediate layer.

20. A manufacturing method of a wafer-level packaging structure, comprising:
preparing a device wafer, the device wafer having a plurality of reference device regions; a reference device being provided within each of the reference device regions;
preparing a thickened intermediate layer wafer, the thickened intermediate layer wafer comprising a plurality of thickened intermediate layer regions; each of the thickened intermediate layer regions comprising a first sub-portion and a second sub-portion that are connected to each other;
aligning and bonding the thickened intermediate layer wafer with a surface of the device wafer where the reference device is arranged; wherein one reference device region of the reference device regions is located within an area surrounded by the first sub-portion, and an orthographic projection of the second sub-portion on the device wafer covers the reference device region.

21. The manufacturing method of a wafer-level packaging structure according to claim 20, wherein
in a direction away from the device wafer, a surface of the second sub-portion away from the first sub-portion is inclined towards a side close to the first sub-portion; and/or,
the surface of the second sub-portion away from the first sub-portion is stepped; and/or,
a plane where the surface of the second sub-portion away from the first sub-portion is located is perpendicular to the device layer.

22. The manufacturing method of a wafer-level packaging structure according to claim 20, wherein forming the thickened intermediate layer wafer comprises:
forming second sealing members and third sealing members on two opposite surfaces of the thickened intermediate layer wafer; forming blocking layers on a surface of the thickened intermediate layer wafer where the third sealing members are located; the third sealing members surround the blocking layers respectively; and
etching the thickened intermediate layer wafer to form via holes; a wall of each of the via holes is a surface of the second sub-portion away from the first sub-portion.

23. The manufacturing method of a wafer-level packaging structure according to claim 22, wherein preparing the device wafer further comprises:
arranging a plurality of functional device regions on the device wafer, a functional device being provided in each functional device region of the functional device regions; and external electromagnetic waves irradiating the functional device along an inclined surface of the second sub-portion away from the first sub-portion;
wherein there is a gap between the functional device region and the reference device region; and the functional device regions are located within boundaries of orthographic projections of the via holes on the device wafer respectively; and
forming fourth sealing members on the device wafer, the fourth sealing members surrounding the reference device regions and the functional device regions respectively;
wherein the fourth sealing members are bonded with the third sealing members of the thickened intermediate layer wafer by solder, and orthographic projections of the blocking layers on the device wafer cover the reference device regions respectively.

24. The manufacturing method of a wafer-level packaging structure according to claim 23, wherein the manufacturing method further comprises:
preparing a capping wafer comprising first sealing members and getters formed on a surface of the capping wafer; and
forming the wafer-level packaging structure using the device wafer, the thickened intermediate layer wafer and the capping wafer; wherein the first sealing members are bonded with the second sealing members of the thickened intermediate layer wafer by solder; and orthographic projections of the getters on the device wafer do not overlap with orthographic projections of the functional device regions on the device wafer.
